# EUROPEAN PATENT APPLICATION

(11) **EP 4 166 618 A1**
(43) Date of publication of application: **19.04.2023**
(21) Application number: 20940732.9
(22) Date of filing: 17.08.2020
(51) Int. Cl.: C09J 7/10, C09J 7/30, C09J 4/06, C09J 4/02, C09J 123/00, H01L 31/048, H01L 23/29

(54) **ADHESIVE FILM, COMPOSITION FOR FORMING SAME AND ELECTRONIC DEVICE**

(30) Priority: 15.06.2020 CN 202010540367
(71) Applicant: Hangzhou First Applied Material Co., Ltd., Hangzhou, Zhejiang 311300 (CN)
(72) Inventor: TANG, Guodong, Hangzhou, Zhejiang 311300 (CN); WANG, Long, Hangzhou, Zhejiang 311300 (CN); SANG, Yan, Hangzhou, Zhejiang 311300 (CN); ZHOU, Guangda, Hangzhou, Zhejiang 311300 (CN); HOU, Hongbing, Hangzhou, Zhejiang 311300 (CN); LIN, Jianhua, Hangzhou, Zhejiang 311300 (CN)
(74) Representative: Casalonga
(86) International application number: PCT/CN2020/109633
(87) International publication number: WO 2021/253611

(57) **Abstract**

Provided are an adhesive film, a composition for forming the same and an electronic device. The composition includes: a thermoplastic polymeric resin and an antistatic agent, herein the antistatic agent is an amide organic compound represented by Formula (I). The above antistatic agent contains a strong-polarity amide group and an optional polar group. The amide group may form an intramolecular hydrogen bond, which has a shorter bond length, and a dipole electric field generated by positive and negative ions formed after ionization is strong and a voltage generated by an external electrostatic field may be counteracted, such that the antistatic agent has a better antistatic property. The optional polar group may further improve the above antistatic property. The thermoplastic polymeric resin has good thermal processability, and after the thermoplastic polymeric resin and the antistatic agent represented by Formula (I) are subjected to melt extrusion, the adhesive film with the better antistatic property and processability may be formed.

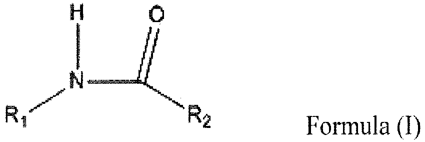

## Description

### Technical Field

The present disclosure relates to the field of photoelectric conversion devices, in particular to an adhesive film, a composition for forming the same, and an electronic device.

### Background

Photoelectric conversion refers to the conversion of solar energy into electric energy by a photovoltaic effect. Common electronic devices (photoelectric conversion devices) capable of achieving the above photoelectric conversion process, include but not limited to a solar battery (such as a crystalline silicon battery, an amorphous silicon battery, a cadmium telluride battery, a copper indium gallium tin battery, and a perovskite battery), a liquid crystal panel, an electroluminescent device, a plasma display device, a sensors and the like. Usually, They need be sealed by one or more layers of a polymer material, and a sealing material is then bonded with an upper substrate and a lower substrate to form a complete electronic device module. For example, a crystalline silicon solar battery module is usually laminated according to a front glass substrate, a front sealing layer polymer, a crystalline silicon battery, a rear sealing layer polymer, a rear glass substrate or a polymer substrate, and then heated and pressurized by a vacuum laminator to form a complete solar module.

The polymer sealing material usually needs to meet the following conditions: I) adhesion. After being heated and melted, the polymer sealing material is bonded to the electronic device and the substrate by chemical action, and it is generally expected that delamination may not occur between the sealing material and the electronic device as well as between the sealing material and the substrate during the long-term use process. 11) Softness. It has the lower elastic modulus, the electronic device is protected from being damaged by an external force; III) Transparency. For example, the solar battery requires the sealing material with the high light transmittance, as to maximize the use of sunlight and improve the power generation efficiency. IV) Insulation. Generally, the polymer sealing material requires the higher volume resistivity, as to avoid a larger leakage current from being generated. V) Chemical stability. While the solar module is exposed to high temperature, high humidity, ultraviolet radiation and the like during the long-term outdoor use, the sealing material should not be seriously deteriorated, resulting in yellowing, mechanical performance degradation, corrosive compound release and the like. VI) Heat resistance. While the solar module is exposed to the long-term high temperature outdoors, the sealing material should not flow or creep, so the sealing material usually needs to be cross-linked.

Generally, a polymer film, especially a polyolefin film, has a higher insulation resistance. In the production and formation process thereof, especially in the friction process with a metal drum, the surface accumulates static electricity easily, thereby the damage to the electronic device is caused in the process of contacting with the electronic device. Generally, an electrostatic elimination device may be added in the polymer film forming process to eliminate the static electricity on the polymer material surface, but this method is not very effective, and the polymer film may accumulate the static electricity again in the use process.

### Summary

A main purpose of the present disclosure is to provide an adhesive film, a composition for forming the same and an electronic device, as to solve a problem that an existing polymer adhesive film is easy to accumulate static electricity on the surface, and the damage to the electronic device may be caused in the process that the adhesive film contacts with the electronic device.

In order to achieve the above purpose, according to one aspect of the present disclosure, a composition for forming an adhesive film is provided, and the composition includes: a thermoplastic polymer resin and an antistatic agent, herein the antistatic agent is an amide organic compound represented by Formula (I),

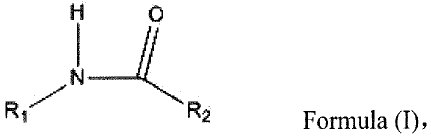

R₁ is H, a group A, a substituent formed by substitution of at least one hydrogen atom in the group A with a hydroxyl, an amino group or an epoxy group, or a substituent formed by substitution of at least one methylene group in the group A with a carbonyl or an ether bond, the group A is a linear alkyl, a branched alkyl or a cycloalkyl, and the carbon atom number of the group A is ≤10; and R₂ is a linear alkyl, a branched alkyl, a cycloalkyl or an alkenyl, and the carbon atom number of R₂ is 2~20.

Further, R₂ is selected from vinyl, allyl, butenyl, pentenyl, hexenyl, heptylenyl, octenyl, decaenyl, undecenyl, dodecenyl, tetradecenyl, hexadecenyl or octadecenyl.

Further, the antistatic agent is selected from one or more in a group consisting of acrylamide, methylacrylamide, N-methylacrylamide, N-ethylacrylamide, N-isopropylacrylamide, N-tert-butyl acrylamide, dimethylaminopropylacrylamide, N-(3-dimethylaminopropyl) methylacrylamide, N-(butoxymethyl)-acrylamide, N-(3-aminopropyl) methylacrylamide, diacetone acrylamide, 4-acryloylmorphine, N-hydroxymethylacrylamide, N-hydroxyethyl acrylamide, N-(2-hydroxypropyl) acrylamide, N,N'-methylenebisacrylamide, N,N'-dimethylene bisacrylamide, maleimide, succinamide, oleic acid amide, 9-hexadeceneamide, N-(2-hydroxyethyl)-undecen-10-enamide, 9-tetradecanenamide, 9-dodecenenamide, 9-decanenamide, octeneamide, hepteneamide, hexeneamide, penteneamide and crotonamide.

Further, calculated by 100 parts by weight of the thermoplastic polymer resin, the above composition further includes: 0.005~0.3 parts of the antistatic agent.

Further, calculated by 100 parts by weight of the thermoplastic polymer resin, the above composition further includes: 0.01∼0.2 parts of the antistatic agent.

Further, calculated by 100 parts by weight of the thermoplastic polymer resin, the above composition further includes: 0.02∼0.1 parts of the antistatic agent.

Further, the thermoplastic polymer resin is selected from one or more in a group consisting of ethylene-vinyl acetate copolymer, ethylene-methyl methacrylate, ethylene-α-olefin copolymer, ethylene homopolymer, polyvinyl butyraldehyde, silicone resin and polyurethane resin.

Further, the density of the ethylene-α-olefin copolymer is 0.86~0.89 g/cm³, and the melt index of the ethylene-α olefin copolymer and the ethylene homopolymer is 1∼40 g/10 min.

Further, the density of the ethylene-α-olefin copolymer is 0.87∼0.88 g/cm³; and the melt index of the ethylene-α olefin copolymer and the ethylene homopolymer is 3~30 g/10 min.

Further, the melt index of the ethylene-α-olefin copolymer and the ethylene homopolymer is 5~25 g/10 min.

Further, the ethylene-α olefin copolymer is a copolymer of ethylene and α-olefm of which the carbon atom number is ≤10, herein the α-olefin of which the carbon atom number is ≤10 is selected from one or more in a group consisting of propylene, 1-butene, 1-hexene, 1-pentene, 1-octene and 4-methyl-1-pentene.

Further, the α-olefin of which the carbon atom number is ≤10 is the 1-butene and/or the 1-octene.

Further, calculated by 100 parts by weight of the thermoplastic polymer resin, the above composition further includes 0.1∼1 parts of an initiator and 0.1∼1.5 parts of a cross-linking agent.

Further, calculated by 100 parts by weight of the thermoplastic polymer resin, the above composition further includes 0.2∼0.9 parts of the initiator and 0.2∼1.2 parts of the cross-linking agent.

Further, calculated by 100 parts by weight of the thermoplastic polymer resin, the above composition further includes 0.3∼0.7 parts of the initiator and 0.3∼1 part of the cross-linking agent.

Further, calculated by 100 parts by weight of the thermoplastic polymer resin, the above composition further includes 0.1∼0.8 parts of a tackifier.

Further, the tackifier is a silane coupling agent with at least one olefinic unsaturated group and at least one hydrolyzable group.

Further, each olefinic unsaturated group is respectively independently selected from vinyl, allyl or γ-(methyl) acryloyloxypropyl, and each hydrolyzable group is respectively independently selected from a methoxy group or an ethoxy group.

Further, the tackifier is selected from one or more in a group consisting of γ-methacryloxypropyltrimethoxysilane, vinyl trimethoxysilane, vinyl triethoxysilane, allyl trimethoxysilane and allyl triethoxysilane.

Further, the above composition further includes one or more of a light stabilizer, an antioxidant, an ultraviolet absorber, a plasticizer, a corrosion inhibitor, a pigment and a filler.

Another aspect of the present disclosure further provides an adhesive film, and the adhesive film is prepared by a melt extrusion process of the above composition.

Another aspect of the present disclosure further provides an electronic device, including a packaging adhesive film, and the packaging adhesive film includes the adhesive film provided in the present application.

A technical scheme of the present disclosure is applied, the antistatic agent represented by Formula (I) contains a strong-polarity amide group and an optional polar group (such as hydroxyl, amino, carbonyl, ether bond or epoxy group). The amide group may form an intramolecular hydrogen bond, which has a shorter bond length, and a dipole electric field generated by positive and negative ions formed after ionization is strong and a voltage generated by an external electrostatic field may be counteracted, such that the antistatic agent has a better antistatic property. The optional polar group (such as hydroxyl, carbonyl or epoxy group) may further improve the above antistatic property. The thermoplastic polymeric resin has good thermal processability, and after the thermoplastic polymeric resin and the antistatic agent represented by Formula (I) are subjected to melt extrusion, the adhesive film with the better antistatic property and processability may be formed.

### Detailed Description of the Embodiments

It should be noted that embodiments in the present application and features in the embodiments may be combined with each other in the case without conflicting. The present disclosure is described in detail below in combination with the embodiments.

As described in the background, the existing polymer adhesive film is easy to accumulate static electricity on the surface, and a problem of the damage to an electronic device may be caused in the process that the adhesive film contacts with the electronic device. In order to solve the above technical problem, the present application provides a composition for forming an adhesive film, and the composition includes: a thermoplastic polymer resin and an antistatic agent, herein the antistatic agent is an amide organic compound represented by Formula (I),

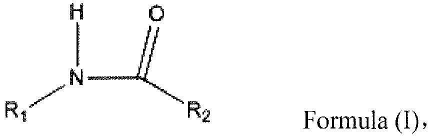

R₁ is H, a group A, a substituent formed by substitution of at least one hydrogen atom in the group A with a hydroxyl, an amino group or an epoxy group, or a substituent formed by substitution of at least one methylene group in the group A with a carbonyl or an ether bond, the group A is a linear alkyl, a branched alkyl or a cycloalkyl, and the carbon atom number of the group A is ≤10; and R₂ is a linear alkyl, a branched alkyl, a cycloalkyl or an alkenyl, and the carbon atom number of R₂ is 2∼20.

The antistatic agent represented by Formula (I) contains a strong-polarity amide group and an optional polar group (such as hydroxyl, amino, carbonyl, ether bond or epoxy group). The amide group may form an intramolecular hydrogen bond, which has a shorter bond length, and a dipole electric field generated by positive and negative ions formed after ionization is strong and a voltage generated by an external electrostatic field may be counteracted, such that the antistatic agent has a better antistatic property. The optional polar group (such as hydroxyl, carbonyl or epoxy group) may further improve the above antistatic property. The thermoplastic polymeric resin has good thermal processability, and after the thermoplastic polymeric resin and the antistatic agent represented by Formula (I) are subjected to melt extrusion, the adhesive film with the better antistatic property and processability may be formed.

Compared with the alkyl, while R₂ is the alkenyl, the antistatic agent may perform a grafting reaction together with the thermoplastic polymer resin, as to improve the uniformity of the intramolecular hydrogen bond dispersion in the adhesive film formed by it, and permanently be locked in the polymer, as well as improve the cross-linking degree of the adhesive film. In order to further reduce the grafting difficulty of the antistatic agent and the polymer resin, reduce the generation of by-products, and improve its cross-linking degree. In a preferred embodiment, R₂ includes but is not limited to vinyl, allyl, butenyl, pentenyl, hexenyl, heptylenyl, octenyl, decaenyl, undecenyl, dodecenyl, tetradecenyl, hexadecenyl or octadecenyl. While the antistatic agent represented by Formula (I) contains one of the above several alkenyls, it is beneficial to further improve the antistatic effect of the packaging adhesive film.

In a preferred embodiment, the antistatic agent includes but is not limited to one or more in a group consisting of acrylamide, methylacrylamide, N-methylacrylamide, N-ethylacrylamide, N-isopropylacrylamide, N-tert-butyl acrylamide, dimethylaminopropylacrylamide, N-(3-dimethylaminopropyl) methylacrylamide, N-(butoxymethyl)-acrylamide, N-(3-aminopropyl) methylacrylamide, diacetone acrylamide, 4-acryloylmorphine, N-hydroxymethylacrylamide, N-hydroxyethyl acrylamide, N-(2-hydroxypropyl) acrylamide, N,N'-methylenebisacrylamide, N,N'-dimethylene bisacrylamide, maleimide, succinamide, oleic acid amide, 9-hexadeceneamide, N-(2-hydroxyethyl)-undecen-10-enamide, 9-tetradecanenamide, 9-dodecenenamide, 9-decanenamide, octeneamide, hepteneamide, hexeneamide, penteneamide and crotonamide. Compared with other types of antistatic agents, the above several antistatic agents have a better stability and a more excellent antistatic property. It is more preferably the N-hydroxymethylacrylamide, N-hydroxyethyl acrylamide, N-(2-hydroxypropyl) acrylamide, N,N'-methylenebisacrylamide, maleimide, oleic acid amide, 9-hexadecaneamide, N-(2-hydroxyethyl)-undecen-10-enamide, 9-tetradecanenamide, 9-dodecanenamide, 9-decanenamide, octeneamide, hepteneamide, hexeneamide, penteneamide and crotonamide, 4-acryloylmorphine.

In order to further improve the antistatic property of the adhesive film, in a preferred embodiment, calculated by 100 parts by weight of the thermoplastic polymer resin, the composition further includes: 0.005∼0.3 parts of an antistatic agent, preferably 0.01~0.2 parts of the antistatic agent, and more preferably 0.02∼0.1 parts of the antistatic agent.

The thermoplastic polymer resin in the above composition may select a resin commonly used in the field. In a preferred embodiment, the thermoplastic polymer resin includes but is not limited to one or more in a group consisting of ethylene-vinyl acetate copolymer, ethylene-methyl methacrylate, ethylene-α-olefin copolymer, ethylene homopolymer, polyvinyl butyraldehyde, silicone resin and polyurethane resin.

Preferably, the above thermoplastic polymer resin is the ethylene-α-olefin copolymer. Compared with other polymers, the ethylene-α-olefin copolymer has the more excellent water vapor barrier property, higher insulation property and higher light transmittance. As a thermoplastic polymer resin, the ethylene-α-olefin copolymer is beneficial to further improve the water vapor barrier property, insulation property and light transmittance of the adhesive film. More preferably, the ethylene-α olefin copolymer is a copolymer of ethylene and α-olefm of which the carbon atom number is ≤10, herein the α-olefm of which the carbon atom number is ≤10 is selected from one or more in a group consisting of propylene, 1-butene, 1-hexene, 1-pentene, 1-octene and 4-methyl-1-pentene; and further preferably, the α-olefin of which the carbon atom number is ≤10 is 1-butene and/or 1-octene.

In a preferred embodiment, the density of the ethylene-α-olefin copolymer is 0.86∼0.89 g/cm³, more preferably 0.87~0.88 g/cm³. If the density of the copolymer is too high, it may affect the light transmittance of the adhesive film; and if the density is too low, the thermoplastic polymer resin may become sticky, and the processability is affected. In a preferred embodiment, the melt index of the ethylene-α olefin copolymer and the ethylene homopolymer is 1~40 g/10 min, more preferably 3~30 g/10 min, and further preferably 5∼25 g/10 min. If the melt index of the thermoplastic polymer resin is too low, it may cause difficulty in forming the adhesive film, and also cause the reduction of wettability of glass and other substrates, thereby the adhesion is reduced; and if the melt index is too high, the packaging adhesive film is easy to stick to the adhesive film or an embossing roller in the production process. In addition, in the pressing process of the electronic device, the polymer has high fluidity after being melted, resulting in glue overflow at the edge. The index of the ethylene-α olefin copolymer and the ethylene homopolymer is defined within the above range, which is beneficial to improve the formability of the adhesive film, the adhesion with a substrate material and the aesthetics of an adhesive film product.

In a preferred embodiment, the above composition further includes an initiator and a cross-linking agent. More preferably, calculated by 100 parts by weight of the thermoplastic polymer resin, the above composition includes 0.1∼1 of the initiator and 0.1~1.5 of the cross-linking agent. Under the action of the free radical initiator and the cross-linking agent, the thermoplastic polymer resin and the antistatic agent are polymerized, and the intramolecular hydrogen bond is formed. The polar group is collected internally, and the molecular surface is mostly a non-polar group, which is not easy to be adsorbed on an inner wall of a container or a surface of a pipe. Therefore, the conductivity attenuation of the adhesive film prepared by the above composition is relatively slow. Therefore, the adhesive film prepared by limiting the amount of each component in the above composition within the above range not only has a good antistatic property, but also has a good insulation property. More preferably, calculated by 100 parts by weight of the thermoplastic polymer resin, the above composition further includes 0.2∼0.9 parts of the initiator and 0.2∼1.2 parts of the cross-linking agent; and further preferably, calculated by 100 parts by weight of the thermoplastic polymer resin, the composition further includes 0.3∼0.7 parts of the initiator and 0.3∼1 part of the cross-linking agent.

The free radical initiator may form an active free radical under the input of energy such as light and heat, thus initiating a cross-linking reaction of the polymer. In the composition for forming the adhesive film provided in the present application, the free radical initiator includes a photoinitiator and a peroxide. The simultaneous addition of the photoinitiator and the peroxide in the above composition is beneficial to improve the reaction activity of the above composition, and thereby it is beneficial to further improve its cross-linking degree, as to improve the comprehensive performance of the adhesive film.

The above photoinitiator and peroxide may select types commonly used in the present application. Preferably, the photoinitiator includes but is not limited to one or more in a group consisting of benzophenone, benzanthrone, benzoin, benzoin alkyl ether, 2,2-diethoxyacetophenone, 2,2-dimethoxy-2-phenylacetophenone, p-phenoxydichloroacetophenone, 2-hydroxyisopropyl-phenyl ketone, 1-phenylpropanedione-2-(ethoxycarbonyl) oxime, 2,4,6-trimethylbenzoyldiphenyl phosphine oxide (DAROCUR@TPO), phenyl bis(2,4,6-trimethylbenzoyl)-phosphine oxide (IRGACURE@819), 2,2-dimethoxy-1,2-diphenylacetophenone (IRGACURE@651), 2-ethoxy-1,2-diphenylacetophenone, 2,2-diethoxy-2-phenylacetophenone, 2,2-diethoxyacetophenone, 2-hydroxycyclohexylphenyl ketone (IRGACURE@184), 2-hydroxyisopropylphenyl ketone (DAROCUR@1173), 2-hydroxy-1-[4-(2-hydroxyethoxy)phenyl]-2-methyl-1-propanone (IRGACURE@2959), 2-methyl-4'-(methylthio)-2-morpholinopropiophenone (IRGACURE@907) and 2-phenyl-2,2-dimethylamino-1-(4-morpholinphenyl)-1-butanone (IRGACURE@369). Preferably, the peroxide includes but is not limited to one or a mixture of more of diacyl peroxide, dialkyl peroxide, ester peroxide, and ketal peroxide. In these organic peroxides, tert-butyl peroxybenzoate, tert-amyl peroxybenzoate, tert-butyl peroxyacetate, tert-amyl peroxyacetate, tert-butyl peroxy-3,5,5-trimethylhexanoate, tert-amyl peroxy-3,5,5-trimethylhexanoate, 2,5-dimethyl-2,5-bis (benzoyl peroxide)-hexane, tert-butyl peroxyisopropyl carbonate, tert-butyl peroxy-2-ethylhexyl carbonate, tert-amyl peroxy-2-ethylhexyl carbonate, tert-amyl peroxyisobutyrate, ethyl 3,3-dis (tert-butylperoxy) butyrate, ethyl 3,3-dis (tert-amylperoxy) butyrate, n-butyl 4,4-bis (tert-butylperoxy) valerate, 2,2-dis (tert-butylperoxy) butane, 1,1-bis (tert-butylperoxy) cyclohexane, 1,1-bis (tert-butylperoxy)-3,3,5-trimethylcyclohexane, 1,1-bis (tert-amylperoxy) cyclohexane, and 1,1-bis (tert-amylperoxy)-3,3,5-trimethylcyclohexane may be listed. Herein, the tert-butyl peroxy-2-ethylhexyl carbonate, tert-amyl peroxy-2-ethylhexyl carbonate, tert-butyl peroxy-3,5,5-trimethylhexanoate, and 1,1-bis (tert-butylperoxy)-3,3,5-trimethylcyclohexane are preferred.

The cross-linking agent is a molecule with a plurality of olefinic unsaturated groups, which may promote the cross-linking of the polymer, as to achieve the higher cross-linking degree. The cross-linking agent in the above composition may select a type commonly used in the field, it is preferably one or more in a group consisting of triallyl isocyanurate, triallyl cyanurate, triallyl cyanate, trimethylolpropane triacrylate, trimethylolpropane trimethacrylate, pentaerythritol tripropylenoate, ethoxylated glycerol tripropionate, tetrahydroxymethyl triacrylate, ethoxylated pentaerythritol tetraacrylate, dimethylolpropane tetraacrylate, trimethylolethane trimethacrylate, pentaerythritol tetraacrylate, tetramethylolmethane tetraacrylate, di-trimethylolpropane tetraacrylate, pentaerythritol tetramethacrylate, tetramethylolmethane tetramethacrylate, di-trimethylolpropane tetramethacrylate, dipentaerythritol polyacrylate, dipentaerythritol hexaacrylate, dipentaerythritol polymethacrylate, dipentaerythritol hexamethacrylate, diethylene glycol dimethacrylate, and 1,6-hexanediol diacrylate, and it is more preferably the triallyl isocyanurate.

In a preferred embodiment, calculated by 100 parts by weight of the thermoplastic polymer resin, the above composition further includes 0.1∼0.8 parts of a tackifier. The amount of the tackifier includes but is not limited to the above range, and it is limited within the above range, which is beneficial to further improve the adhesion between the adhesive film and the substrate material. More preferably, calculated by 100 parts by weight of the thermoplastic polymer resin, the above composition includes 0.15∼0.6 parts of the tackifier, and further preferably, calculated by 100 parts by weight of the thermoplastic polymer resin, the above composition includes 0.2∼0.5 parts of the tackifier.

The above tackifier may select a type commonly used in the field. In a preferred embodiment, the tackifier is a silane coupling agent with at least one olefinic unsaturated group and at least one hydrolyzable group. The introduction of the olefinic group may make the tackifier chemically combine with the polymer, and the introduction of the hydrolyzable group (such as a methoxy group or an ethoxy group) may make the tackifier bond with the substrate or the electronic device in the heating process. More preferably, each olefinic unsaturated group is respectively independently selected from vinyl, allyl or γ-(methyl) acryloyloxypropyl, and each hydrolyzable group is respecrtively independently selected from the methoxy group or the ethoxy group; and the tackifier is selected from one or more in a group consisting of γ-methacryloxypropyltrimethoxysilane, vinyl trimethoxysilane, vinyl triethoxysilane, allyl trimethoxysilane and allyl triethoxysilane.

In order to further improve the comprehensive performance of the adhesive film, some additives may also be added to the above composition. In a preferred embodiment, the above additives include one or more in a group consisting of a light stabilizer, an antioxidant, an ultraviolet absorber, a plasticizer, a corrosion inhibitor, a pigment and a filler.

The light stabilizer is used to improve the stability of the packaging adhesive film under long-term ultraviolet radiation. Preferably, the light stabilizer is a hindered amine compound. More preferably, the above light stabilizer includes but is not limited to one or more in a group consisting of bis(2,2,6,6-tetramethyl-4-piperidyl) sebacate, bis(1-octyloxy-2,2,6,6-tetramethyl-4-piperidyl) sebacate, a graft copolymer obtained by polymerization of 4-(methyl) acryloyloxy-2,2,6,6-tetramethylpiperidine with α-olefinic monomer, 4-hydroxy-2,2,6,6-tetramethyl-1-piperidol, 3,5-di-tert-butyl-4-hydroxy-benzoic acid hexadecyl ester, bis-2,2,6,6-tetramethylpiperidol sebacate and tri(1,2,2,6,6,6-pentamethyl-4-piperidinyl) phosphite. In order to further improve the light stability of the adhesive film, preferably, calculated by 100 parts by weight of the thermoplastic polymer resin, in the above the composition, the amount of the light stabilizer is 0.02∼0.8 parts, preferably 0.05∼0.6 parts, and more preferably 0.1∼0.5 parts.

The antioxidant is used to improve the stability of the polymer during the extrusion process and the long-term use process, and delay the degradation generated due to thermal oxidation. In a preferred embodiment, the antioxidant is a hindered phenolic compound and/or a phosphite ester compound. Compared with other antioxidants, the above antioxidant has a better stability and oxidation resistance. More preferably, the hindered phenolic compound includes but is not limited to one or more in a group consisting of 2,6-di-tert-butyl-4-ethylphenol, 2,2'-methylene-bis-(4-methyl-6-tert-butylphenol), 2,2'-methylene-bis-(4-ethyl-6-tert-butylphenol), 4,4'-butylene-bis-(3-methyl-6-tert-butylphenol), octadecyl-3-(3,5-di-tert-butyl-4-hydroxyphenyl) propionate, pentaerythritol-tetra[3-(3,5-di-tert-butyl-4-hydroxyphenyl) propionate], 7-octadecyl-3-(4'-hydroxy-3',5'-di-tert-butylphenyl) propionate and tetra-[methylene-3-(3',5'-di-tert-butyl-4'-hydroxyphenyl) propionate] methane; and the phosphite ester compound includes but is not limited to one or more in a group consisting of tris(2,4-di-tert-butylphenyl) phosphite, bis[2,4-bis(1,1-dimethylethyl)-6-methylphenyl] ethyl ester phosphite, tetra(2,4-di-tert-butylphenyl)[1,1-diphenyl]-4,4'-diylbisphosphite and bis(2,4-di-tert-butylphenyl) pentaerythritol diphosphite. In order to further improve the oxidation resistance of the adhesive film, preferably, calculated by 100 parts by weight of the thermoplastic polymer resin, in the above the composition, the amount of the antioxidant is 0.005∼0.5 parts, more preferably 0.01∼0.4 parts, further preferably 0.02∼0.3 parts, more further preferably 0.03∼0.2 parts.

The ultraviolet absorber refers to a compound that may absorb most of ultraviolet energy and convert it into heat, as to protect some electronic devices from being damaged by ultraviolet light. In a preferred embodiment, the above ultraviolet absorber is selected from benzophenone and/or benzotriazole. More preferably, the ultraviolet absorber includes but is not limited to one or more in a group consisting of 2-hydroxy-4-n-octyloxybenzophenone, 2,2-tetramethylene bis(3,1-benzoxazine-4-one), 2-(2'-hydroxy-5-methylphenyl) benzotriazole, 2,2'-dihydroxy-4,4'-dimethoxy benzophenone, 2-(2'-hydroxy-3',5'-di[1,1-dimethylphenyl]phenyl)-benzotriazole, 2-(2'-hydroxy-3'-tert-butyl-5'-methylphenyl)-5-chlorobenzotriazole, 2-(2'-hydroxy-3',5'-di-tert-butylphenyl)-5-chlorobenzotriazole and 2-(2'-hydroxy-3',5'-di-tert-amylphenyl)-benzotriazole. In order to further improve the anti-ultraviolet performance of the adhesive film formed by it, in a preferred embodiment, calculated by 100 parts by weight of the thermoplastic polymer resin, in the above the composition, the amount of the ultraviolet absorber is 0.05∼0.5 parts, more preferably 0.1~0.4 parts, and further preferably 0.2∼0.3 parts.

The plasticizer may reduce an intermolecular force between polymer molecules, and reduce a friction force between a polymer melt and a metal surface during processing, as to enhance the plasticity of the polymer and facilitate the processing. In a preferred embodiment, the plasticizer includes but is not limited to one or more in a group consisting of a phthalate ester coumpound, an aliphatic dibasic acid ester coumpound, a phosphate coumpound, a polyethylene wax coumpound and a stearic acid coumpound; and more preferably, the plasticizer includes but is not limited to one or more in a group consisting of polyethylene wax, trialkyl phosphate, triaryl phosphate, dioctyl sebacate, dioctyl adipate, dodecyl dicarboxylate, dioctyl phthalate, dibutyl phthalate, stearic acid, zinc stearate and calcium stearate, and the number average molecular weight of the plasticizer is 2000∼10000. In order to further improve the processability of the adhesive film, in a preferred embodiment, calculated by 100 parts by weight of the thermoplastic polymer resin, in the above the composition, the amount of the plasticizer is 0.01~5 parts, more preferably 0.05∼4 parts, further preferably 0.1~3 parts, and more further preferably 0.3∼2 parts.

The corrosion inhibitor refers to a compound that may absorb a free acid in the adhesive film, including a metal oxide and a metal hydroxide. The metal oxide is preferably one or more in a group consisting of a magnesium oxide, a zinc oxide and a calcium oxide; and the hydroxide is preferably a magnesium hydroxide and/or a calcium hydroxide. In a preferred embodiment, calculated by 100 parts by weight of the thermoplastic polymer resin, in the above the composition, the amount of the corrosion inhibitor is 0.05∼0.3 parts, preferably 0.08∼0.2 parts.

The pigment may make the packaging adhesive film colored and have the light transmittance, so that the packaged electronic device becomes beautiful. The pigment includes an inorganic pigment and an organic pigment, and it may be selected from any one or a mixture of iron nickel yellow, titanium chrome brown, cobalt green, iron red, iron yellow, cobalt blue, copper chrome black, ultramarine blue, indigo, cinnabar, realgar, cadmium red, cadmium yellow, iron blue, lithopone, iron oxide red and iron oxide yellow.

In a preferred embodiment, calculated by 100 parts by weight of the thermoplastic polymer resin, in the above the composition, the amount of the pigment is 0.1~10 parts, more preferably 0.5∼8 parts, further preferably 1~7 parts, and more further preferably 2∼6 parts.

The filler is an inorganic compound that may endow the packaging adhesive film with light reflecting or light absorbing properties, and it is preferably one or more in a group consisting of titanium dioxide, calcium carbonate, lithopone, aluminum oxide, aluminum doped zinc oxide, indium tin oxide, antimony oxide, barium sulfate, montmorillonite, kaolin, talc, feldspar powder, and carbon black. In order to further improve the reflectivity of the adhesive film and thus increase the power of the electronic device, more preferably, the amount of the filler is 1~40 parts, preferably 2~30 parts, more preferably 3~20 parts, and further preferably 4~15 parts.

Another aspect of the present application further provides an adhesive film, and the adhesive film is prepared by a melt extrusion process of the above composition provided by the present application. The antistatic agent represented by Formula (I) contains a strong-polarity amide group. The amide group may form an intramolecular hydrogen bond, which has a shorter bond length. Positive and negative ions are generated after ionization of antistatic agent. A dipole electric field formed by the positive and negative ions is strong and a voltage generated by an external electrostatic field may be counteracted by the dipole electric field. So the antistatic agent has a better antistatic property. The thermoplastic polymeric resin has good thermal processability, and after the thermoplastic polymeric resin and the antistatic agent represented by Formula (I) are subjected to melt extrusion, the adhesive film with the better antistatic property may be formed.

Preferably, the thickness of the electronic device packaging adhesive film provided by the present disclosure is between 0.1 mm and 0.8 mm, has low surface resistance, may prevent the accumulation of static electricity, and is suitable for packaging a variety of electronic devices, especially a solar battery module.

Another aspect of the present application further provides an electronic device, including a packaging adhesive film, and the packaging adhesive film includes the adhesive film provided in the present application.

The adhesive film provided in the present application not only has a better anti-static effect, but also may guarantee a good insulation of the adhesive film. The comprehensive performance of the electronic device may be greatly improved by selecting it as the packaging adhesive film.

Another aspect of the present disclosure further provides a preparation method for an electronic device packaging adhesive film, including:
(1) Mixing. In a mixer, raw materials except for thermoplastic polymer resin particles are continuously sprayed into the thermoplastic polymer resin particles in the form of liquid (a liquid additive or a solid additive is dissolved in a solvent to form solution), and obtain a mixture. And the mixture is stirred for several hours or kept in mixing motion, until the liquid is completely absorbed by the polymer particles. It is also possible to granulate the solid or liquid additive with the polymer particles to form a master particle by a granulator, and then it is added to the polymer particles in the form of the master particle.
(2) The mixed material is added into a screw extruder, and the mixed composition is melted and meshed by the screw extruder so that the reaction raw materials are mixed uniformly. At a tail end of the extruder, the melt is extruded by a wide-slit-type nozzle. After the nozzle, the surface embossing is performed with the aid of an embossing roller and a rubber roller, and then it is rolled after being cooled by a cooling roller, to form a coiled adhesive film, thereby the present disclosure is completed.

The present application is further described in detail below in combination with specific embodiments, and these embodiments may not be understood as limiting a scope of protection claimed by the present application.

### Embodiment 1

0.005 parts of acrylamide was weighed, and dissolved with an appropriate amount of anhydrous ethanol, to form a solution. The solution was uniformly sprayed into 100 parts of polymer (POE) particles (DOW Engage 8669, melt index: 14 g/10 min, and density: 0.873 g/cc) and stirred, until the ethanol was volatilized, and the surface of the POE particles was dry. The dried POE particles were added into a single screw extruder. An uniform POE melt were formed by the melting and shearing action of a screw. A film was extruded and formed by a wide-slit-type nozzle, the texture structure was formed on the surface of the film by the extrusion action of an embossing roller and a rubber roller. Then the film was cooled by a plurality of cooling rollers, and finally it was rolled by a winding roller. The thickness of the film was 0.5 mm.

### Embodiment 2

0.3 parts of oleic acid amide was weighed, and dissolved with an appropriate amount of anhydrous ethanol, to form a solution. The solution was uniformly sprayed into 100 parts of POE particles (DOW Engage 8669) and stirred, until the ethanol was volatilized, and the surface of the POE particles was dry. The dried POE particles were added into a single screw extruder. An uniform POE melt were formed by the melting and shearing action of a screw. A film was extruded and formed by a wide-slit-type nozzle, the texture structure was formed on the surface of the film by the extrusion action of an embossing roller and a rubber roller Then the film was cooled by a plurality of cooling rollers, and finally it was rolled by a winding roller. The thickness of the film was 0.5 mm.

### Embodiment 3

0.05 parts of N-hydroxymethylacrylamide, 0.6 parts of tert-butyl peroxy-2-ethylhexyl carbonate (TBEC), 0.5 parts of triallyl isocyanurate (TAIC), 0.25 parts of γ-methacryloxypropyltrimethoxysilane (KH570), 0.1 parts of sebacic acid bis-2,2,6,6-tetramethylpiperidol ester (Tinuvin 770), and 0.2 parts of 2-hydroxy-4-n-octyloxybenzophenone (Cyasorb 531) were weighed, and dissolved with an appropriate amount of anhydrous ethanol, to form a solution. The solution was uniformly sprayed into 100 parts of POE particles (DOW Engage 8669) and stirred, until the ethanol was volatilized, and the surface of the POE particles was dry. The dried POE particles were added into a single screw extruder. An uniform POE melt were formed by the melting and shearing action of a screw. A film was extruded and formed by a wide-slit-type nozzle, the texture structure was formed on the surface of the film by the extrusion action of an embossing roller and a rubber roller. Then the film is cooled by a plurality of cooling rollers, and finally it is rolled by a winding roller. The thickness of the film was 0.5 mm.

### Embodiment 4

0.02 parts of N,N'-methylene bisacrylamide, 0.7 parts of benzophenone (BP), 0.4 parts of triallyl isocyanurate (TAlC), 0.4 parts of trimethylolpropane triacrylate (TMPTA), 0.25 parts of 3-(trimethoxysilyl)propyl methacrylate (KH570), and 0.1 parts of (bis(2,2,6,6-tetramethylpiperidin-4-yl) decanedioate) Tinuvin 770 were weighed, and dissolved with an appropriate amount of anhydrous ethanol, to form a solution. 1 part of iron oxide red, 1 part of iron oxide yellow, 0.5 parts of polyethylene wax and 100 parts of POE particles (DOW Engage 8669) were mixed and granulated by a double-screw granulator to form orange transparent granulating particles. And the prepared solution were uniformly sprayed into the prepared granulating particles and stirred, until the ethanol was volatilized, and the surface of the POE particles was dry. The dried POE particles were added into a single screw extruder, to form a uniform POE melt by the melting and shearing action of a screw. A film was extruded and formed by a wide-slit-type nozzle, the texture structure was formed on the surface of the film by the extrusion action of an embossing roller and a rubber roller. Then the film was cooled by a plurality of cooling rollers, and finally it was rolled by a winding roller to obtain an orange transparent adhesive film. The thickness of the film was 0.5 mm.

### Embodiment 5

0.1 parts of maleimide, 0.5 parts of TBEC, 0.5 parts of TAIC, 0.5 parts of TMPTA, 0.25 parts of KH570, and 0.07 parts of Tinuvin 770 were weighed, and dissolved with an appropriate amount of anhydrous ethanol, to form solution; 7 parts of titanium dioxide and 100 parts of POE particles (Dow Engage 8669) were mixed and granulated by a double-screw granulator to form white granulating particles; and the prepared solution was uniformly sprayed into the prepared granulating particles and stirred, until the ethanol was volatilized, and the surface of the POE particles was dry. The dried POE particles were added into a single screw extruder, to form a uniform POE melt by the melting and shearing action of a screw. A film was extruded and formed by a wide-slit-type nozzle, the texture structure was formed on the surface of the film by the extrusion action of an embossing roller and a rubber roller, then it was cooled by a plurality of cooling rollers, and finally it was rolled by a winding roller to obtain a white adhesive film. The thickness of the film was 0.5 mm.

### Embodiment 6

A difference from Embodiment 3 is that: the antistatic agent was acrylamide.

### Embodiment 7

A difference from Embodiment 3 is that: the antistatic agent was dimethylaminopropylacrylamide.

### Embodiment 8

A difference from Embodiment 3 is that: the antistatic agent was diacetone acrylamide.

### Embodiment 9

A difference from Embodiment 3 is that: the antistatic agent was 4-acryloylmorpholine.

### Embodiment 10

A difference from Embodiment 3 is that: the antistatic agent was oleic acid amide.

### Embodiment 12

A difference from Embodiment 3 is that: the thermoplastic polymer resin was an ethylene-propylene hydrocarbon copolymer, with a density of 0.88 g/cm³ and a melt index of 30 g/10 min.

### Embodiment 13

A difference from Embodiment 3 is that: the thermoplastic resin was ethylene-methyl methacrylate.

### Embodiment 14

A difference from Embodiment 3 is that: the tackifier was not added.

### Embodiment 15

A difference from Embodiment 3 is that: the tackifier was propenyl triethoxysilane.

### Contrast example 1

A material for forming the adhesive film only contains POE particles, a preparation method was the same as that in Embodiment 1, the adhesive film with a patterned surface was obtained, and the thickness of the film was 0.5 mm.

### Contrast example 2

A difference from Embodiment 3 is that: the antistatic agent was not added, a preparation method was the same as that in Embodiment 3, the adhesive film with a patterned surface was obtained, and the thickness of the film was 0.5 mm.

### Contrast example 3

A difference from Embodiment 4 is that: the antistatic agent was not added, a preparation method was the same as that in Embodiment 3, the adhesive film with a patterned surface was obtained, and the thickness of the film was 0.5 mm.

### Determination method

### (1) Volume resistivity

An obtained film slice was cut into a size of 10 cm×10 cm. At 150°C, it was vacuumized for 5 minutes, pressurized for 13 minutes, and laminated by a laminating device, so that the pattern on the surface of the adhesive film was removed, to obtain the adhesive film with a flat surface. The adhesive film was cross-linked (if the cross-linking agent is added). On the other hand, the adhesive films of Embodiment 4 and Contrast example 3 were irradiated by ultraviolet light, and the irradiation dose was 5 J/cm²; and the adhesive film of Embodiment 5 was irradiated by an electron beam, and the irradiation dose was 5 kGy.

According to IEC62,788-1-2 method A, the volume resistivity (Ω• cm) of the obtained film slice was measured under 1000 V of an applied voltage and 1 h of polarization, and results were shown in Table 1.

### (2) Surface resistivity

An obtained film slice was cut into a size of 10 cm×10 cm. At 150°C, it is vacuumized for 5 minutes, pressurized for 13 minutes, and laminated by a laminating device, so that the pattern on the surface of the adhesive film is removed, to obtain the adhesive film with a flat surface. On the other hand, the adhesive film is cross-linked (if the cross-linking agent is added). On the other hand, the adhesive films of Embodiment 4 and Contrast example 3 are irradiated by ultraviolet light, and the irradiation dose is 5 J/cm²; and the adhesive film of Embodiment 5 is irradiated by an electron beam, and the irradiation dose is 5 kGy.

According to GB/T 1410-2006, the surface resistivity Ω of the obtained film slice is measured under 1000 V of an applied voltage and 1 h of polarization, and results are shown in Table 1.

### (3) Cross-linking degree

An obtained film slice was cut into a size of 10 cm×10 cm. At 150°C, it was vacuumized for 5 minutes, pressurized for 13 minutes, and laminated by a laminating device, so that the pattern on the surface of the adhesive film was removed, to obtain the adhesive film with a flat surface. The adhesive film was cross-linked (if the cross-linking agent is added). On the other hand, the adhesive films of Embodiment 4 and Contrast example 3 were irradiated by ultraviolet light, and the irradiation dose was 5 J/cm²; and the adhesive film of Embodiment 5 was irradiated by an electron beam, and the irradiation dose is 5 kGy.

About 1 g of the obtained film slice (the weighing value was A (g)) was weighed, boiling xylene was used to perform Soxhlet extraction for 5 hours, a 30-mesh stainless steel filter screen was used to filter, and then the screen was dried at 145°C for 3 hours under a reduced pressure, the residual amount B (g) on the screen was calculated, and the cross-linking degree was calculated by the following formula. Cross-linking degree (weight%) = B/A ×100%. Test results of the adhesive films formed in Embodiments 1 to 15 and Contrast examples 1 to 3 are shown in Table 1.

**Table 1**

| | Cross-linking degree % | Volume resistivity, 10¹⁶[Ω.cm] | Surface resistivity, 10¹⁵Ω |
|---|---|---|---|
| Embodiment 1 | 0 | 6.9 | 7.3 |
| Embodiment 2 | 0 | 74 | 5.1 |
| Embodiment 3 | 75 | 23 | 9.2 |
| Embodiment 4 | 70 | 18 | 4.9 |
| Embodiment 5 | 74 | 12 | 21 |
| Embodiment 6 | 75 | 11 | 10.6 |
| Embodiment 7 | 76 | 21 | 8.5 |
| Embodiment 8 | 76 | 20 | 9.2 |
| Embodiment 9 | 76 | 19 | 10.4 |
| Embodiment 10 | 75 | 17 | 11 |
| Embodiment 11 | 74 | 22 | 21 |
| Embodiment 12 | 69 | 21 | 15 |
| Embodiment 13 | 68 | 1.5 | 14 |
| Embodiment 14 | 71 | 20 | 15.5 |
| Embodiment 15 | 78 | 26 | 15 |
| Contrast example 1 | 0 | 7.1 | 66 |
| Contrast example 2 | 76 | 38 | 45 |
| Contrast example 3 | 71 | 27 | 52 |

From the above description, it may be seen that the above embodiments of the present disclosure achieve the following technical effects.

By comparing Embodiments 1 to 15 and Contrast examples 1 to 3, it may be seen that the adhesive film prepared by the composition provided in the present application has the higher cross-linking degree and antistatic property.

By comparing Embodiments 1 to 11, it may be seen that the use of the antistatic agent preferred in the present application is beneficial to improve the antistatic property of the adhesive film.

By comparing Embodiments 3, 12 and 13, it may be seen that the selection of the specific thermoplastic resin is beneficial to improve the comprehensive performance of the adhesive film.

By comparing Embodiments 3, 14 and 15, it may be seen that the selection of the tackifier preferred in the present application is beneficial to improve the comprehensive performance of the adhesive film.

It should be noted that terms "first", "second" and the like in the description and claims of the present application are used to distinguish similar objects, not necessarily to describe a specific sequence or a precedence order. It should be understood that the terms so used are interchangeable in an appropriate case, so that implementation modes of the present application described herein, for example, may be implemented in a sequence other than those described herein.

The above are only preferred embodiments of the present disclosure, and are not intended to limit the present disclosure. For those skilled in the art, the disclosure may have various changes and variations. Any modifications, equivalent replacements, improvements and the like made within the spirit and principle of the present disclosure shall be included in a scope of protection of the present disclosure.

## Claims

1. A composition for forming an adhesive film, wherein the composition comprises: a thermoplastic polymer resin and an antistatic agent, wherein the antistatic agent is an amide organic compound represented by Formula (I), 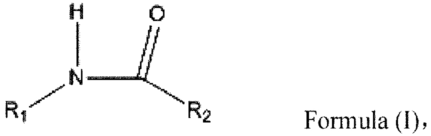
R₁ is H, a group A, a substituent formed by substitution of at least one hydrogen atom in the group A with a hydroxyl, an amino group or an epoxy group, or a substituent formed by substitution of at least one methylene group in the group A with a carbonyl or an ether bond, the group A is a linear alkyl, a branched alkyl or a cycloalkyl, and the carbon atom number of the group A is ≤10; and
R₂ is a linear alkyl, a branched alkyl, a cycloalkyl or an alkenyl, and the carbon atom number of R₂ is 2∼20.

2. The composition according to claim 1, wherein R₂ is selected from vinyl, allyl, butenyl, pentenyl, hexenyl, heptylenyl, octenyl, decaenyl, undecenyl, dodecenyl, tetradecenyl, hexadecenyl or octadecenyl.

3. The composition according to claim 2, wherein the antistatic agent is selected from one or more in a group consisting of acrylamide, methylacrylamide, N-methylacrylamide, N-ethylacrylamide, N-isopropylacrylamide, N-tert-butyl acrylamide, dimethylaminopropylacrylamide, N-(3-dimethylaminopropyl) methylacrylamide, N-(butoxymethyl)-acrylamide, N-(3-aminopropyl) methylacrylamide, diacetone acrylamide, 4-acryloylmorphine, N-hydroxymethylacrylamide, N-hydroxyethyl acrylamide, N-(2-hydroxypropyl) acrylamide, N,N'-methylenebisacrylamide, N,N'-dimethylene bisacrylamide, maleimide, succinamide, oleic acid amide, 9-hexadeceneamide, N-(2-hydroxyethyl)-undecen-10-enamide, 9-tetradecanenamide, 9-dodecenenamide, 9-decanenamide, octeneamide, hepteneamide, hexeneamide, penteneamide and crotonamide.

4. The composition according to any one of claims 1 to 3, wherein calculated by 100 parts by weight of the thermoplastic polymer resin, the composition further comprises: 0.005∼0.3 parts of the antistatic agent.

5. The composition according to claim 4, wherein calculated by 100 parts by weight of the thermoplastic polymer resin, the composition further comprises: 0.01∼0.2 parts of the antistatic agent.

6. The composition according to claim 5, wherein calculated by 100 parts by weight of the thermoplastic polymer resin, the composition further comprises: 0.02∼0.1 parts of the antistatic agent.

7. The composition according to claim 4, wherein the thermoplastic polymer resin is selected from one or more in a group consisting of ethylene-vinyl acetate copolymer, ethylene-methyl methacrylate, ethylene-α-olefin copolymer, ethylene homopolymer, polyvinyl butyraldehyde, silicone resin and polyurethane resin.

8. The composition according to claim 7, wherein the density of the ethylene-α-olefin copolymer is 0.86∼0.89 g/cm³, and the melt index of the ethylene-α olefin copolymer and the ethylene homopolymer is 1~40 g/10 min.

9. The composition according to claim 8, wherein the density of the ethylene-α-olefin copolymer is 0.87∼0.88 g/cm³; and the melt index of the ethylene-α olefin copolymer and the ethylene homopolymer is 3∼30 g/10 min.

10. The composition according to claim 9, wherein the melt index of the ethylene-α-olefin copolymer and the ethylene homopolymer is 5∼25 g/10 min.

11. The composition according to claim 7, wherein the ethylene-α olefin copolymer is a copolymer of ethylene and α-olefin of which the carbon atom number is ≤10, and the α-olefin of which the carbon atom number is ≤10 is selected from one or more in a group consisting of propylene, 1-butene, 1-hexene, 1-pentene, 1-octene and 4-methyl-1-pentene.

12. The composition according to any one of claims 5 to 11, wherein calculated by 100 parts by weight of the thermoplastic polymer resin, the composition further comprises 0.1∼1 parts of an initiator and 0.1∼1.5 parts of a cross-linking agent.

13. The composition according to claim 12, wherein calculated by 100 parts by weight of the thermoplastic polymer resin, the composition further comprises 0.2∼0.9 parts of the initiator and 0.2∼1.2 parts of the cross-linking agent.

14. The composition according to claim 13, wherein calculated by 100 parts by weight of the thermoplastic polymer resin, the composition further comprises 0.3∼0.7 parts of the initiator and 0.3∼1 part of the cross-linking agent.

15. The composition according to claim 12, wherein calculated by 100 parts by weight of the thermoplastic polymer resin, the composition further comprises 0.1~0.8 parts of a tackifier.

16. The composition according to claim 15, wherein the tackifier is a silane coupling agent with at least one olefinic unsaturated group and at least one hydrolyzable group.

17. The composition according to claim 16, wherein each olefinic unsaturated group is respectively independently selected from vinyl, allyl or γ-(methyl) acryloyloxypropyl, and each hydrolyzable group is respecrtively independently selected from a methoxy group or an ethoxy group.

18. The composition according to claim 17, wherein the tackifier is selected from one or more in a group consisting of γ-methacryloxypropyltrimethoxysilane, vinyl trimethoxysilane, vinyl triethoxysilane, allyl trimethoxysilane and allyl triethoxysilane.

19. The composition according to claim 12, wherein the composition further comprises one or more of a light stabilizer, an antioxidant, an ultraviolet absorber, a plasticizer, a corrosion inhibitor, a pigment and a filler.

20. An adhesive film, wherein the adhesive film is prepared by a melt extrusion process of the composition according to any one of claims 1 to 19.

21. An electronic device, comprising a packaging adhesive film, wherein the packaging adhesive film comprises the adhesive film according to claim 20.
